# FASCICULE DE BREVET EUROPEEN

(11) **EP 0 321 326 B1**
(45) Date de publication et mention de la délivrance du brevet: **26.05.1993**
(21) Numéro de dépôt: 88403139.4
(22) Date de dépôt: 09.12.1988
(51) Int. Cl.: H01L 23/50, H01L 21/48

(54) **Procédé de mise en place sur un support, d'un composant électronique, muni de ses contacts**
Verfahren zum Anbringen eines elektronischen Bauelementes auf einem Substrat
Method for positioning an electronic component on a substrate

(30) Priorité: 14.12.1987 FR 8717387
(43) Date de publication de la demande: 21.06.1989
(73) Titulaire: SGS-THOMSON MICROELECTRONICS S.A., 94250 Gentilly (FR)
(72) Inventeur: Gloton, Jean-Pierre, F-75116 Paris (FR)
(74) Mandataire: Ballot, Paul Denis Jacques

(56) Documents cités:
- EP-A- 0 197 438
- EP-A- 0 213 764
- GB-A- 2 081 974

## Description

L'invention concerne un procédé pour mettre en place sur un support tel qu'une carte d'identification ou une carte bancaire un composant électronique et ses contacts de manière que le composant soit logé dans une cavité et que ses contacts soient disposés sur la carte.

Il est courant d'utiliser des cartes d'identification dans de nombreux domaines, notamment dans celui des cartes bancaires ou de crédit. Pendant très longtemps, ces cartes ne comportèrent, outre un numéro d'identification et le nom du titulaire, qu'un enregistrement magnétique qui en permettait l'identification par lecture magnétique. Depuis quelques années, ces cartes sont utilisées à d'autres fonctions que l'identification du titulaire et en particulier à des fins de pré-paiement et de protection contre les actions des fraudeurs. A cet effet, la carte comporte un composant électronique actif qui peut être constitué d'une mémoire électronique associée ou non à un microprocesseur, ce qui permet de l'utiliser notamment pour des applications de type bancaire.

Les cartes de crédit de cette technique, qui comportent un composant électronique, sont fabriquées de diverses manières. Selon un premier procédé, une cavité est aménagée dans l'épaisseur de la carte pour recevoir le composant électronique. Selon un autre procédé, dit de ''co-laminage", on lamine de fines couches de matière plastique : polyépoxy, polyéthylène, polychrome de vinyl etc... autour du composant. Lors de la mise en oeuvre de ces procédés, diverses opérations sont en outre effectuées pour assurer la connexion électrique des bornes du composant électronique à des métallisations qui sont disposées en surface sur la carte.

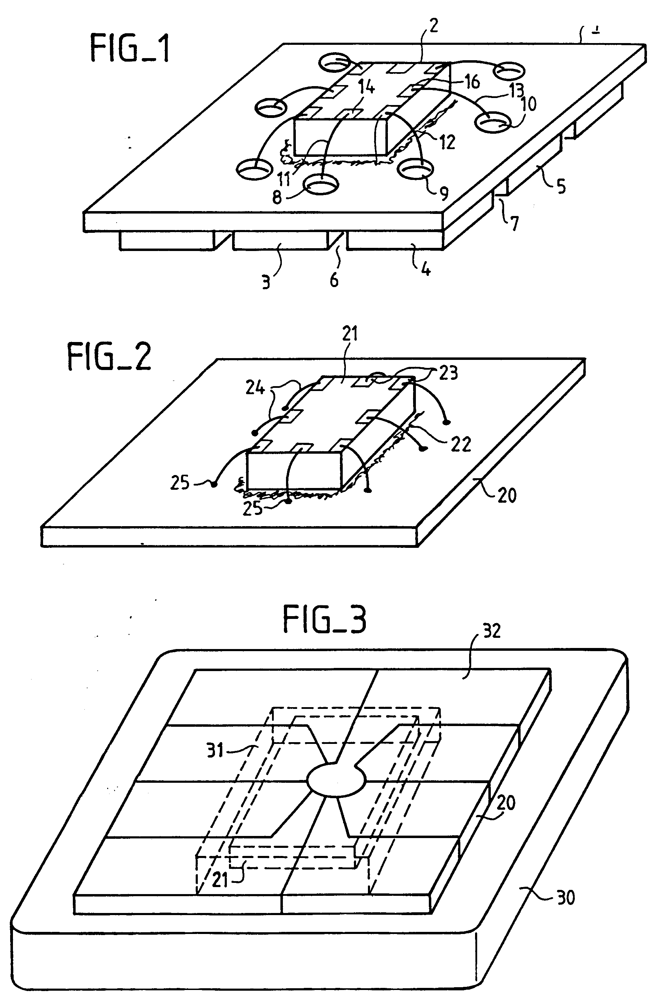

L'un des procédés pour mettre en place le composant électronique dans la cavité aménagée dans la carte et pour disposer les métallisations sur la carte ainsi que pour réaliser les connexions entre les bornes de la carte et les métallisations, consiste, comme le montre la figure 1, à utiliser un film 1 non conducteur, par exemple en polyépoxy, qui porte d'un côté le composant électronique sous forme d'une "puce" (référence 2) et de l'autre côté des surfaces métallisées, telles que celles référencées 3,4 et 5, et séparées les unes des autres par des espaces 6 et 7 sans métallisation. Ces surfaces métallisées 3,4 et 5 communiquent avec l'autre coté du film 1 par des trous 8,9 et 10 par l'intermédiaire desquels les extrémités des fils conducteurs 11, 12 et 13 viennent se connecter aux surfaces métallisées correpondantes par tout moyen connu, tel qu'une colle conductrice. L'autre extrémité de chaque fil conducteur est connectée à une borne de sortie 14, 15 ou 16 de la puce 2.

Ces opérations sont ensuite suivies de l'enrobage de la puce 2 avec de la résine et d'une cuisson de la résine pour obtenir l'encapsulation de la puce. On peut alors mettre en place la puce dans la cavité de la carte et disposer les métallisations sur les bords de la cavité par simple emboîtage de la puce et collage du film support 1 sur la carte après son découpage aux dimensions requises.

Le procédé qui vient d'être décrit succinctement ci-dessus présente l'inconvénient suivant : le film 1 et la colle qui est utilisée pour maintenir les métallisations 3,4 et 5 ne peuvent supporter des températures supérieures à 150°C ; il en résulte un allongement considérable du temps de cuisson de la résine qui sert à encapsuler la puce 2, ce qui est coûteux, notamment dans une chaîne de fabrication automatique.

Selon le procédé connu de GB-A-2 081 974 de mise en place d'un composant électronique et de ses connexions électriques sur un support, une cavité pour loger le composant est formée dans le support tel qu'une carte à microcircuits; une couche métallique est déposée sur ce support et découpée en zones de contact isolées électriquement l'une de l'autre de manière que chaque zone corresponde à une borne de sortie du composant; le composant est mis en place sur le support de manière qu'il se loge dans la cavité et soit fixé sur la couche métallique; les bornes de sortie du composant sont raccordées aux zones de contact; et enfin le composant et ses connexions électriques sont enrobés dans une résine appropriée.

Selon un procédé connu de EP-A-0 197 438 on prépare une couche métallique ayant des zones de contact formées par découpage. Une pastille en matière synthétique est fixée sur cette couche métallique et ses zones de contact. La pastille comporte une cavité pour loger un composant électronique. Après fixation du composant dans la cavité ses bornes de sortie sont raccordées électriquement aux zones de contact de la couche métallique. Enfin le composant électronique et ses connexions électriques sont enrobés dans une résine appropriée.

Le but de la présente invention est donc de remédier aux inconvénients précités en mettant en oeuvre un procédé de mise en place d'un composant électronique et de ses connexions électriques sur un support qui permette une plus haute température de cuisson de la résine d'enrobage, d'où un temps de cuisson plus faible et donc un coût moins élevé. L'invention se rapporte donc à un procédé de mise en place d'un composant électronique et de ses connexions électriques sur un support comportant dans sa surface supérieure une cavité pour loger ledit composant, comprenant les opérations suivantes:
a) le dépôt d'une couche métallique sur un support de travail tel qu'une plaquette;
b) la fixation du composant électronique sur ladite couche métallique dans une région centrale de celle-ci;
c) le raccordement électrique des bornes de sortie du composant électronique à certains endroits déterminés de la couche métallique au moyen des connexions électriques ;
d) l'encapsulation du composant électronique et de ses connexions électriques dans une résine appropriée ;
e) la mise en place de l'ensemble composant électronique-couche métallique sur le support de manière que le composant électronique et ses connexions électriques se logent dans la cavité et que le pourtour de la couche métallique vienne en contact avec la surface supérieure du support et soit fixé sur ledit support ;
f) le découpage de la couche métallique en zones de contact isolées électriquement l'une de l'autre de manière que chaque zone de contact corresponde à une borne de sortie du composant.

D'autres caractéristiques et avantages de la présente invention apparaîtront à la lecture de la description suivante d'un exemple particulier de réalisation, ladite description étant faite en relation avec le dossier joint dans le quel :
- la figure 1 est une vue en perspective cavalière d'un film de support de composant électronique et ses connexions électriques mettant en oeuvre un procédé selon l'art antérieur ;
- la figure 2 est une vue en perspective cavalière d'un composant électronique collé sur une couche métallique uniforme à laquelle sont raccordées électroniquement les bornes de sortie du composant ;
- la figure 3 est une vue en perspective cavalière d'une carte sur laquelle est collé l'ensemble de la figure 2, ladite vue montrant les dernières opérations qui sont effectuées conformément au procédé selon l'invention.
La figure 1 correspond à l'art antérieur et a été décrite dans le préambule. Sur la figure 2, la première opération du procédé consiste à réaliser une couche métallique 20, par exemple en nickel, sur un support de travail non représenté. Cette couche métallique a une épaisseur uniforme de quelques dizaines de microns, par exemple quatre-vingt microns. Au centre de cette couche, on fixe un composant électronique 21 à l'aide d'une colle 22.

Le composant électronique non enrobé peut être d'abord fixé sur la couche métallique, puis les connexions électriques sont réalisées : ses bornes de sortie électriques 23 sont connectées, par tout procédé connu, à des endroits déterminés 25 de la couche métallique 20, par l'intermédiaire de fils conducteurs 24.

Ensuite, une opération d'encapsulation du composant et des connexions électriques est effectuée de manière à protéger ces deux éléments.

Lorsqu'on dispose de la pièce de la figure 2, l'opération suivante consiste à assembler cette pièce sur la carte d'identification 30 (figure 3). A cet effet, la carte comporte une cavité 31 dans laquelle vient se loger le composant électronique 21 et ses connexions électriques 24 et 25, ceci étant obtenu par retournement de la pièce de la figure 2. Dans cette opération, le pourtour de la couche métallique 20 vient en contact avec la surface supérieure de la carte 30, qui entoure la cavité 31. Ce pourtour est fixé sur la surface supérieure par tout moyen connu, par exemple à l'aide d'une colle.

La deuxième opération consiste à effectuer le découpage de la couche métallique 20 de manière à obtenir une zone de contact 32 par connexion électrique, chaque zone étant évidemment isolée électriquement l'une de l'autre. Le dessin de découpage est par exemple celui montré sur la figure 3. Il permet d'obtenir huit zones de contact.

Ce découpage peut être réalisé de différentes manières, telles que l'attaque chimique par l'intermédiaire d'un masque ou l'enlèvement mécanique du métal par microfraisage mécanique ou à l'aide d'un appareil à laser. Bien entendu, ce découpage est limité en profondeur à l'épaisseur de la couche métallique et il n'y a donc d'attaque importante du boîtier du composant électronique 21.

Il est habituel, pour différentes raisons, que la surface extérieure des zones de contact 32 soit recouverte d'or. Pour cela, une couche d'or est déposée avant l'opération de découpage. Dans ce cas, il faut prévoir l'enlèvement de la couche d'or à l'endroit des découpes, ce qui est obtenu lors du fraisage mécanique ou par laser ou à l'aide d'un masque dans un procédé chimique.

Le procédé qui vient d'être décrit n'utilise pas de film de support, ni de colle de fixation des contacts sur le film, ce qui simplifie les opérations et évite donc les limitations en température apportées par ces deux éléments au cours de l'opération d'encapsulation.

## Revendications

1. Procédé de mise en place d'un composant électronique (21) et de ses connexions électriques (24) sur un support (30) comportant dans sa surface supérieure une cavité (31) pour loger ledit composant, comprenant les opérations suivantes :
a) le dépôt d'une couche métallique (20) sur un support de travail tel qu'une plaquette;
b) la fixation du composant électronique (21) sur ladite couche métallique (20) dans une région centrale de celle-ci;
c) le raccordement électrique des bornes de sortie (23) du composant électronique à certains endroits déterminés (25) de la couche métallique (20) au moyen des connexions électriques (24);
d) l'encapsulation du composant électronique (21) et de ses connexions électriques (24) dans une résine appropriée;
e) la mise en place de l'ensemble composant électronique-couche métallique sur le support (30) de manière que le composant électronique (21) et ses connexions électriques se logent dans la cavité (31) et que le pourtour de la couche métallique (20) vienne en contact avec la surface supérieure du support (30) et soit fixé sur ledit support (30).
f) le découpage de la couche métallique (20) en zones de contact (32) isolées électriquement l'une de l'autre de manière que chaque zone de contact (32) corresponde à une borne de sortie du composant (21).

2. Procédé selon la revendication 1, caractérisé en ce que l'opération de découpage de la couche métallique (20) est effectuée par une attaque chimique avec masque.

3. Procédé selon la revendication 1, caractérisé en ce que l'opération de découpage de la couche métallique (20) est effectuée par microfraisage mécanique.

4. Procédé selon la revendication 1, caractérisé en ce que l'opération de découpage de la couche métallique (20) est effectuée par microfraisage à l'aide d'un dispositif laser.

## Claims

1. A method of fitting an electronic component (21) and its electrical connections (24) on a support (30) having in its upper surface a cavity (31) for housing the said component, comprising the following operations:
(a) depositing a metallic layer (20) on a working support such as a wafer;
(b) securing the electronic component (21) on the said metallic layer (20) in a central region of the latter;
(c) electrically connecting the output terminals (23) of the electronic component to certain predetermined positions (25) on the metallic layer (20) by means of electrical connections (24);
(d) encapsulating the electronic component (21) and its electrical connections (24) in an appropriate resin;
(e) fitting the assembly comprising the electronic component and the metallic layer on the support (30) in such a way that the electronic component (21) and its electrical connections are housed in the cavity (31), with the perimeter of the metallic layer (20) making contact with the upper surface of the support (30) and being fixed on the said support (30);
(f) cutting out the metallic layer (20) into contact zones (32), which are electrically insulated from each other in such a way that each contact zone (32) corresponds to one output terminal of the component (21).

2. A method according to Claim 1, characterised in that the operation of cutting out the metallic layer (20) is carried out by means of a chemical etching process using masking.

3. A method according to Claim 1, characterised in that the operation of cutting out the metallic layer (20) is carried out by mechanical micro-milling.

4. A method according to Claim 1, characterised in that the operation of cutting out the metallic layer (20) is carried out by micro-milling using a laser device.

## Patentansprüche

1. Verfahren zum Anbringen eines elektronischen Bauteils (21) und seiner elektrischen Verbindungen (24) auf einem Träger (30), der in seiner oberen Fläche eine Aussparung (31) enthält, um das Bauteil aufzunehmen, das folgende Verfahrensschritte aufweist:
a) Aufbringen einer Metallschicht (20) auf einen Arbeitsträger, wie ein Plättchen;
b) Befestigen des elektronischen Bauteils (21) auf der Metallschicht (20) im mittleren Bereich von dieser;
c) elektrisches Verbinden der Ausgangsklemmen (23) des elektronischen Bauteils mit bestimmten festgelegten Stellen (25) der Metallschicht (20) mittels elektrischer Verbindungen (24);
d) Einkapselung des elektronischen Bauteils (21) und seiner elektrischen Verbindungen (24) mit einem geeigneten Harz;
e) Anbringen der aus dem elektronischen Bauteil und der Metallschicht bestehenden Anordnung derart auf dem Träger (30), daß das elektronische Bauteil (21) und seine elektrischen Verbindungen in der Aussparung (31) untergebracht werden und daß der Umfang der Metallschicht (20) in Kontakt mit der oberen Fläche des Trägers (30) kommt und auf dem Träger (30) befestigt wird;
f) Trennen der Metallschicht (20) in Kontaktzonen (32), die voneinander elektrisch isoliert sind, derart daß jede Kontaktzone (32) einer Ausgangsklemme des Bauteils (21) entspricht.

2. Verfahren nach Anspruch 1, dadurch gekennzeichnet, daß der Verfahrensschritt des Trennens der Metallschicht (20) durch chemisches Ätzen mit einer Maske durchgeführt wird.

3. Verfahren nach Anspruch 1, dadurch gekennzeichnet, daß der Verfahrensschritt des Trennens der Metallschicht (20) durch mechanisches Mikrofräsen durchgeführt wird.

4. Verfahren nach Anspruch 1, dadurch gekennzeichnet, daß der Verfahrensschritt des Trennens der Metallschicht (20) durch Mikrofräsen mit Hilfe einer Laservorrichtung durchgeführt wird.
